Europäisches Patentamt

(19) European Patent Office

Office européen des brevets

(11) Veröffentlichungsnummer: **0 348 643 B1**

# (12) EUROPÄISCHE PATENTSCHRIFT

(45) Veröffentlichungstag der Patentschrift:
27.12.91 Patentblatt 91/52

(51) Int. Cl.⁵: **H03K 5/08**

(21) Anmeldenummer: **89108459.2**

(22) Anmeldetag: **11.05.89**

(54) Schwellenwertschaltung mit geregelter Ansprechschwelle.

(30) Priorität: **15.06.88 CH 2298/88**

(43) Veröffentlichungstag der Anmeldung:
**03.01.90 Patentblatt 90/01**

(45) Bekanntmachung des Hinweises auf die Patenterteilung:
**27.12.91 Patentblatt 91/52**

(84) Benannte Vertragsstaaten:
**CH DE FR GB IT LI NL SE**

(56) Entgegenhaltungen:
**FR-A- 2 484 737**
**US-A- 3 860 794**
**US-A- 4 263 555**
**US-A- 4 571 547**
**IBM TECHNICAL DISCLOSURE BULLETIN, Band 16, Nr. 1, Juni 1973, Seiten 273-274, New York, US; O. ROTH et al.: "Self-adjustable waveform squaring circuit"**

(73) Patentinhaber: **SIEMENS-ALBIS AKTIENGESELLSCHAFT PVP/Verträge und Patente Postfach CH-8047 Zürich (CH)**

(84) Benannte Vertragsstaaten:
**CH LI**
Patentinhaber: **SIEMENS AKTIENGESELLSCHAFT Wittelsbacherplatz 2 W-8000 München 2 (DE)**

(84) Benannte Vertragsstaaten:
**DE FR GB IT NL SE**

(72) Erfinder: **Basedau, Philipp Gyrenstrasse 3 CH-8967 Widen (CH)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft eine Schwellenwertschaltung nach dem Oberbegriff des Patentanspruchs 1.

Zum Trennen von Nutz- und Störsignalen in Impulsübertragungsstrecken werden oft Schaltungsanordnungen verwendet, die eintreffende Signale mit einem Schwellenwert vergleichen und die entsprechend der Grösse dieser Signale im Vergleich zum Schwellenwert numerische Signale vom Wert Null oder Eins abgeben. Der Schwellenwert wird dabei vorzugsweise entsprechend der halben Höhe der eingehenden Datensignale gewählt. Diese Bedingung kann jedoch über längere Zeit nur mit einem variablen Schwellenwert eingehalten werden, der z.B. der Amplitude der eingehenden Datensignale angepasst wird.

Eine Schwellenwertschaltung mit regelbarem Schwellenwert ist aus der FR-A-2484737 bekannt. Dabei wird ein z.B. von einem Plattenspeicher ausgelesenes sinusförmiges PCM — Signal der Schwellenwertschaltung zugeführt, die dieses in ein Rechtecksignal umwandelt. Durch eine nachgeschaltete Regelungsstufe wird ferner die Pulsbreite der erzeugten Rechtecksignale gemessen und durch Regelung des Schwellenwertes auf einem gewünschten Wert gehalten. Diese Schaltung dient daher zur Umwandlung eines sinusförmigen Signals in ein Rechtecksignal und ist zur Trennung von Nutz- und Störsignalen nur schlecht geeignet.

In der nachveröffentlichten CH-A-668871 ist eine weitere Schwellenwertschaltung dieser Art beschrieben. Bei dieser Schaltung wird ein Nutzsignal mit Hilfe einer Schwellenspannung von Störsignalen unterschieden, die vorteilhafterweise etwa dem halben Wert der Amplitude der empfangenen Signale entspricht. Da in vielen Fällen, z.B. durch Temperaturschwankungen oder durch Änderungen in der Kabellänge, die Amplitude der Eingangssignale ändert, wird die Schwellenspannung in Abhängigkeit von der Amplitude der Eingangssignale gesteuert.

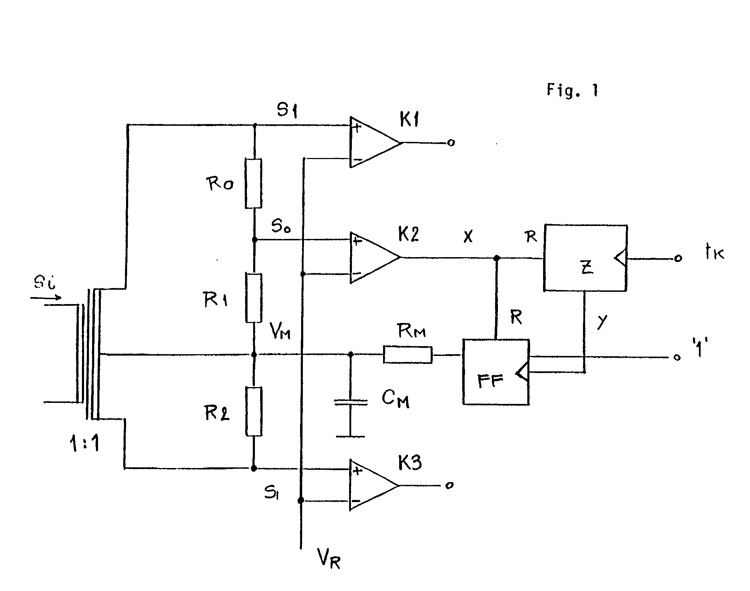

Fig. 1 zeigt den prinzipiellen Aufbau von oben erwähnter Schaltung. Die Spannung $s_1$ am Eingang des Komparators $K_1$ entsteht aus der Überlagerung des 1 : 1 transformierten Eingangssignals $s_i$ auf eine Steuerspannung $V_M$, d.h. $s_1 = s_i + V_M$. Da die Widerstände $R_0$ und $R_1$ äquivalent sind, ist die Spannung $S_0 = 1/2\,s_i + V_M$. Die Spannung $S_0$ wird nun über einen Regelkreis, bestehend aus einem Komparator $K_2$, einem Zähler Z, einer Kippstufe FF, einem Widerstand $R_M$ und einem Kondensator $C_M$, durch Variieren der Steuerspannung $V_M$ derart geregelt, dass sie den Wert einer Referenzspannung $V_R$ annimmt. Ein Komparator $K_1$ vergleicht nun die Spannung $s_1$, welche aus der Überlagerung von neu eintreffenden Signalen auf die Steuerspannung $V_M$ besteht ($s_1 = s_{i\,(neu)} + V_M$), mit der Spannung $V_R$, welche der Überlagerung der halben Amplitude der früher eingetroffenen Eingangssignale $s_i$ auf die Spannung $V_M$ entspricht ($V_R = 1/2\,s_{i\,(alt)} + V_M$). Da der Wert der Steuerspannung $V_M$, welcher in $s_1$ enthalten ist, mit dem Wert der Steuerspannung $V_M$ in der letzten Gleichung identisch ist, werden nun neue Eingangssignale mit dem Schwellenwert, d.h. mit der halben Amplitude der früher angekommenen Signale (= $1/2\,s_{i\,(alt)}$) verglichen. Ein Wert $s_{i(neu)} > 1/2\,s_{i\,(alt)}$ wird vom Komparator $K_1$ als Signal mit dem Wert logisch '1' weitergegeben. Negative Eingangssignale mit gleichem Betrag werden vom Komparator $K_3$ als Signale mit dem Wert logisch '1' weitergegeben.

Der erwähnte Regelkreis funktioniert dabei folgendermassen : Der Komparator $K_2$ vergleicht die Spannung $S_0$ (= $1/2\,s_{i\,(neu)} + V_M$) mit der Referenzspannung $V_R$. Bei einem Zustand $S_0 > V_R$ nimmt der Ausgang des Komparators $K_2$ den Wert logisch '1' an. Dadurch werden der Zähler Z und die Kippstufe FF zurückgesetzt und der Kondensator $C_M$ wird über den Widerstand $R_M$ entladen. Bei einem Zustand $S_0 < V_R$ nimmt der Ausgang des Komparators $K_2$ hingegen den Wert logisch 'O' an und der Zähler Z, der mit dem Taktsignal tk beaufschlagt ist, beginnt zu zählen. Falls der Zustand $S_0 < V_R$ während der gesamten Zählperiode, d.h. während der Durchlaufzeit des Zählers Z, erhalten bleibt, nimmt nach deren Ablauf, d.h. mit einer durch die Zählperiode gegebenen Verzögerung, der Ausgang des Zählers Z den Wert y = '1' an. Dadurch wird die Kippstufe FF getaktet und erhält am Ausgang den Wert logisch '1', wodurch der Kondensator $C_M$ über den Widerstand $R_M$ geladen wird, bis die Spannung $S_0$ wieder grösser als die Referenzspannung $V_R$ wird. Die durch den Zähler Z bewirkte Verzögerung soll die Wahrscheinlichkeit verringern, dass das Eintreffen einer Serie von Datennullen zum Laden des Kondensators $C_M$ führt.

Da hauptsächlich mit sehr langsamen Änderungen der Amplitude der Eingangssignale zu rechnen ist, erfolgt die Steuerung der Spannung $V_M$ in obiger Schaltung nicht fein genug. Nach einer längeren Serie von Datennullen nimmt die Ansprechschwelle ab, da sich der Wert der Spannung $V_M$ relativ schnell dem Wert der Referenzspannung $V_R$ nähert. Ein Störsignal, das kleiner ist als die halbe Signalamplitude, wird dann eventuell in unerwünschter Weise als Signal mit dem Wert logisch '1' weitergegeben. Zudem ist in dieser Schaltung der Steuerbereich der Spannung $V_M$ nicht frei wählbar.

Der vorliegenden Erfindung liegt daher die Aufgabe zugrunde, diese Schwellenwertschaltung zu verbessern. Mit den im Patentanspruch 1 beschriebenen Massnahmen wird der Steuerbereich der Spannung $V_M$ derart festgelegt, dass nach einer extrem langen Serie von Datennullen eine restliche Schwellenspannung erhalten bleibt und dass auch bei hohen Amplituden der Eingangssignale der gewünschte Schwellenwert eingehalten wird. Die im Anspruch 2 angegebenen Massnahmen ermöglichen eine feine Regelung der Spannung VM. Im Anspruch 3 ist die Möglichkeit einer Schaltungsvereinfachung angegeben.

Anhand einer Zeichnung wird die Erfindung nachfolgend beispielsweise näher erläutert Dabei zeigt :

Fig. 1    die eingangs beschriebene Schwellenwertschaltung
Fig. 2    ein Ausführungsbeispiel der erfindungsgemässen Schaltung nach Anspruch 1
Fig. 3    ein Ausführungsbeispiel der erfindungsgemässen Schaltung nach Anspruch 2

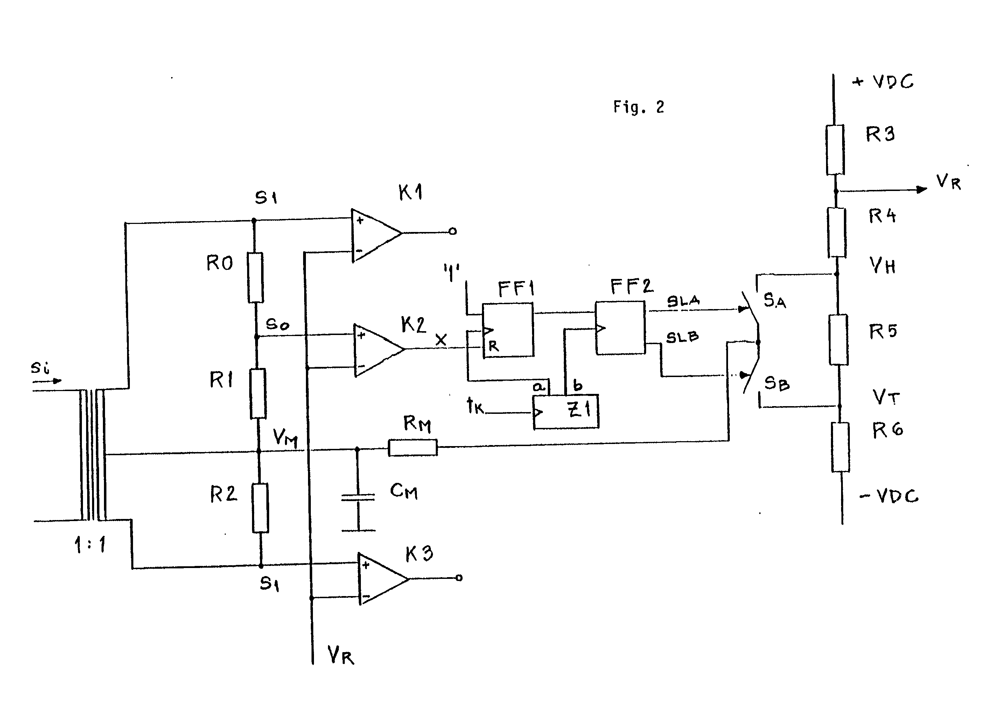

Fig. 2 zeigt die aus Fig. 1 bekannte Schaltung, deren Zähler Z und Kippstufe FF durch einen zwei den Zählerständen a, b entsprechende Ausgänge aufweisenden Zähler $Z_1$, zwei Kippstufen $FF_1$ und $FF_2$, zwei Schalter $S_A$, $S_B$ und vier Widerstände $R_2$, $R_3$, $R_4$ und und $R_5$ ersetzt wurden. Beschrieben wird nachfolgend vor allem der durch die genannten Elemente neu gebildete Regelkreis.

Im neuen Regelkreis wird wiederum eine Spannung $s_0$ mit einer Referenzspannung $V_R$ verglichen und davon abhängig wird der Kondensator $C_M$ durch Anlegen einer Spannung $V_H$ oder $V_T$ über die Schalter $S_A$, $S_B$ geladen bzw. entladen. Das Anlegen der Spannung $V_H$ oder $V_T$ erfolgt dabei während der gesamten Zählperiode des Zählers Z1. Der während der Zähldauer von Zählerstand a bis b auftretende Zustand $s_0 > V_R$ führt beim Eintreten des Zählerstandes b durch Anlegen der Spannung $V_T$ immer zum Entladen des Kondensators $C_M$. Der Zustand $s_0 < V_R$, der auch bei einer Serie von ankommenden Datennullen während längerer Zeit eintritt, führt, nach Aufrechterhaltung des Zustands $s_0 < V_R$ über die Zähldauer von Zählerstand a bis b, durch Anlegen der Spannung $V_H$ beim Eintreten des Zählerstandes b zum Laden des Kondensators $C_M$. Besonders vorteilhaft bei dieser Schaltung ist, dass der nach einer extrem langen Serie von Datennullen maximal auftretende Wert der Steuerspannung $V_M$ durch die Spannung $V_H$ gegeben ist. Da die Spannung $V_H$ kleiner ist als die Referenzspannung $V_R$, bleibt am Eingang der Komparatoren $K_1$ und $K_3$ eine restliche Schwellenspannung mit dem Wert $V_R$-$V_H$ erhalten. Für die Spannung $V_T$ können auch negative Werte gewählt werden. Dies stellt sicher, dass $s_0$ auch bei grossen Amplituden der Eingangssignale $s_i$ immer den Wert der Referenzspannung $V_R$ annehmen kann (z.B. $1/2\ s_{i(neu)} - |V_M| = V_R$).

Dementsprechend funktioniert der Regelkreis gemäss Fig. 2 im einzelnen wie folgt :

Das Ausgangssignal x des Komparators $K_2$ wird dem Reset — Eingang der Kippstufe $FF_1$ zugeführt. Bei x = '1' wird die Kippstufe $FF_1$ sofort zurückgesetzt. Falls der Zustand x = '1' während einer Zählperiode nie eingetreten ist, befindet sich der Ausgang der Kippstufe $FF_1$ immer noch im Zustand logisch '1', der vom D-Eingang beim letzten Taktimpuls (Zählerstand a) übernommen wurde. Beim Eintreffen des Zählerstandes b erhält die Kippstufe $FF_2$ einen Taktimpuls und übernimmt den Wert vom Ausgang der Kippstufe $FF_1$. Falls x ursprünglich gleich logisch '1' war (bei $s_0 > V_R$) und die Kippstufe $FF_1$ somit zurückgesetzt wurde, hat der Ausgang SLA der Kippstufe $FF_2$ nach dem Taktimpuls den Wert logisch '0' und der Ausgang SLB den Wert logisch '1'. Beim Erreichen des Zählerstandes b wird der Schalter $S_B$ aktiviert und der Kondensator $C_M$ wird über den Widerstand $R_M$ durch Anlegen der Spannung $V_T$ entladen. Falls x ursprünglich während einer ganzen Zählperiode logisch '0' war und die Kippstufe $FF_1$ nicht zurückgesetzt wurde, ist der Ausgang SLA der Kippstufe $FF_2$ nach dem Taktimpuls nun logisch '1' und der Ausgang SLB gleich logisch '0'. Beim Eintreffen des Zählerstandes b wird der Schalter $S_A$ aktiviert und der Kondensator $C_M$ wird über den Widerstand $R_M$ durch Anlegen der Spannung $V_H$ geladen.

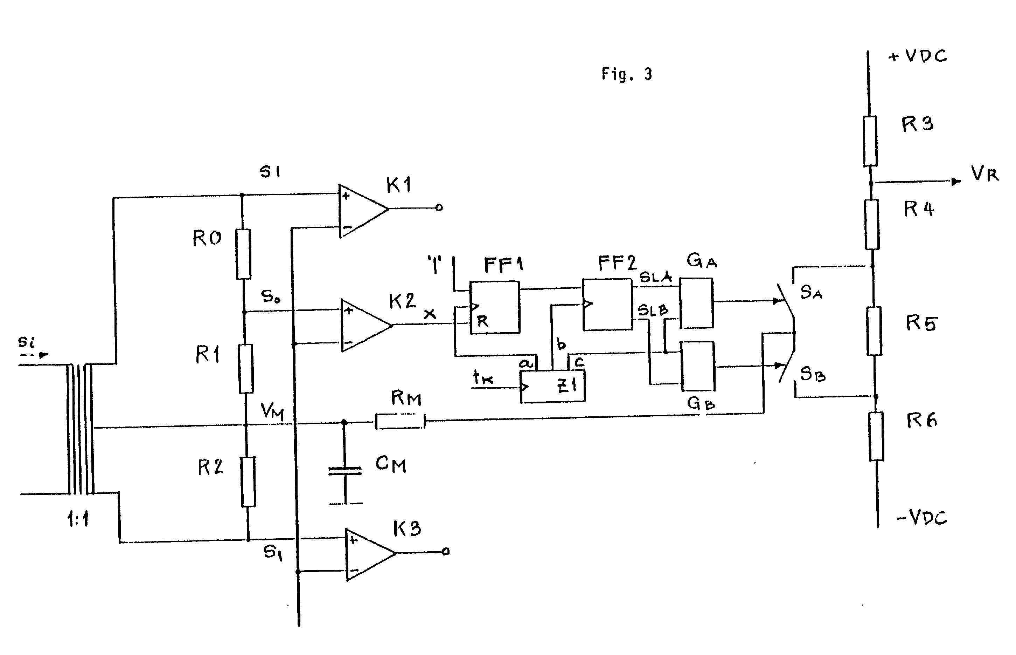

Fig. 3 zeigt die aus Fig. 2 bekannte Schaltung, in der zwischen der Kippstufe FF2 und den Schaltern $S_A$, $S_B$ zwei UND — Tore $G_A$, $G_B$ so eingefügt sind, dass die beiden Ausgänge SLA, SLB der Kippstufe FF2 je mit einem Eingang der UND — Tore $G_A$, $G_B$ verbunden sind, deren zweiter Eingang auf einen dritten Ausgang c des Zählers Z1 geführt ist und deren Ausgänge je mit dem Steuereingang eines Schalters $S_A$, $S_B$ verbunden sind.

In dieser Schaltung werden die Werte der Ausgänge SLA, SLB der Kippstufe FF2 durch die UND — Tore $G_A$, $G_B$ nur während dem Zählerstand c des Zählers Z1 zu den Steuereingängen der Schalter $S_A$, $S_B$ weitergeleitet. Das Laden oder Entladen des Kondensators $C_M$ erfolgt nur sehr kurzzeitig, so dass eine sehr feine Regelung der Spannung $V_M$ ermöglicht wird.

Falls für Z1 ein einfacherer Zähler gewählt wird, dessen intern verbundene Ausgänge a und b zum selben Zeitpunkt aktiv werden, führt ein Zustand $s_0 > V_R$, der während der gesamten Zählperiode (Zählerstand a bis a) ein- oder mehrmals auftritt, durch Anlegen der Spannung $V_T$ beim Eintreffen des Zählerstandes c immer zum Entladen des Kondensators $C_M$. Umgekehrt muss der Zustand $s_0 < V_R$ während der gesamten Zählperiode erhalten bleiben, damit der Kondensator $C_M$ durch Anlegen der Spannung $V_M$ geladen wird. Die Kippstufen FF1 und FF2 bilden in diesem Fall ein zweistufiges Schieberegister.

## Patentansprüche

1. Schwellenwertschaltung mit regelbarer Ansprechschwelle, insbesondere zum Trennen der Nutzsignale von Störsignalen in Regenerativverstärkern in Impulsübertragungsstrecken, mit einem Regelungsglied, das durch Auf- bzw. Entladung eines Kondensators ($C_M$) die den Schwellenwert bestimmende Spannung ($V_M$) steuert **dadurch gekennzeichnet,** dass das Eingangssignal (s1) dem nicht-invertierenden Eingang eines Komparators (K1) und über einen Spannungsteiler dem nicht-invertierenden Eingang eines Komparators (K2) zugeführt wird, dass das Ausgangssignal (x) des Komparators (K2) dem Reset-Eingang einer ersten Kippstufe (FF1) zugeführt ist, deren Takteingang mit dem ersten Ausgang (a) eines mindesten zwei Zählausgänge (a, b) aufweisenden Zählers (Z1) und deren nicht-invertierender Ausgang mit dem Eingang einer zweiten Kippstufe (FF2) verbunden ist, deren Takteingang mit dem zweiten Ausgang (b) des Zählers (Z1) verbunden ist, und dass die Ausgänge (SLA, SLB) der Kippstufe (FF2) je mit dem Steuereingang eines Schalters ($S_A$, $S_B$) verbunden sind, wobei bei durchgeschaltetem erstem Schalter ($S_A$) ein den Kondensator ($C_M$) ladendes erstes Potential ($V_H$) und bei durchgeschaltetem zweitem Schalter ($S_B$) ein den Kondensator ($C_M$) entladendes zweites Potential ($V_T$) angeschaltet ist, wobei das zweite Potential ($V_T$) negativer als das erste Potential ($V_H$) und das erste Potential ($V_H$) negativer als ein Referenzpotential (VR) ist, das mit den invertierenden Eingängen der Komparatoren (K1, K2) verbunden ist.

2. Schwellenwertschaltung nach Anspruch 1, **dadurch gekennzeichnet,** dass zwischen der Kippstufe (FF2) und den Schaltern ($S_A$, $S_B$) zwei UND—Tore ($G_A$, $G_B$) so eingefügt sind, dass die beiden Ausgänge (SLA, SLB) der Kippstufe (FF2) je mit einem Eingang der UND — Tore ($G_A$, $G_B$) verbunden sind, deren zweiter Eingang auf einen dritten Ausgang (c) des Zählers (Z1) geführt ist und deren Ausgänge je mit dem Steuereingang eines Schalters ($S_A$, $S_B$) verbunden sind.

3. Schwellenwertschaltung nach Anspruch 1 und 2, **dadurch gekennzeichnet,** dass die Zählerausgänge (a) und (b) beim gleichen Zählerstand den Wert logisch '1' annehmen.

## Claims

1. Threshold value circuit with adjustable response threshold, in particular for separating the useful signals from interference signals in regenerative amplifiers in pulse transmission paths, having an adjustment element which controls the voltage ($V_M$), determining the threshold value, by means of the charging and discharging of a capacitor ($C_M$), characterized in that the input signal (s1) is supplied to the non-inverting input of a comparator (K1) and by means of a voltage divider to the non-inverting input of a comparator (K2), in that the output signal (x) of the comparator (K2) is supplied to the reset input of a first flip-flop stage (FF1), the clock input of which is connected to the first output (a) of a counter (Z1) having at least two counting outputs (a, b), and the non-inverting output of which is connected to the input of a second flip-flop stage (FF2), the clock input of which is connected to the second output (b) of the counter (Z1), and in that the outputs (SLA, SLB) of the flip-flop stage (FF2) are each connected to the control input of a switch ($S_A$, $S_B$), whereby with first switch ($S_A$) connected through, a first potential ($V_H$) charging the capacitor ($C_M$) is connected and with second switch ($S_B$) connected through, a second potential ($V_T$) discharging the capacitor ($C_M$) is connected, whereby the second potential ($V_T$) is more negative than the first potential ($V_H$) and the first potential ($V_H$) is more negative than a reference potential (VR) which is connected to the inverting inputs of the comparators (K1, K2).

2. Threshold value circuit according to claim 1, characterized in that between the flip-flop stage (FF2) and the switches ($S_A$, $S_B$) two AND-gates ($G_A$, $G_B$) are inserted in such a way that the two outputs (SLA, SLB) of the flip-flop stage (FF2) are each connected to an input of the AND-gates ($G_A$, $G_B$), the second input of which is guided on to a third output (c) of the counter (Z1) and the outputs of which are each connected to the control input of a switch ($S_A$, $S_B$).

3. Threshold value circuit according to claim 1 and 2, characterized in that the counter outputs (a) and (b) with the same count assume the value logical '1'.

## Revendications

1. Circuit à valeur de seuil comportant un seuil de réponse réglable, notamment pour séparer les signaux utiles de signaux parasites dans des amplificateurs à régénération dans des sections de transmission d'impulsions, et comportant un circuit de régulation qui, au moyen de la charge et de la décharge d'un condensateur ($C_M$), commande la tension ($V_M$) déterminant la valeur de seuil, caractérisé par le fait que le signal d'entrée (s1) est envoyé à l'entrée non inverseuse d'un comparateur (K1) et, par l'intermédiaire d'un diviseur de tension,

4

à l'entrée non inverseuse d'un comparateur (K2), que le signal de sortie (x) du comparateur (K2) est envoyé à l'entrée de remise à l'état initial d'un premier étage à bascule (FF1), dont l'entrée de cadence est raccordée à la première sortie (a) d'un compteur (ZE) possédant au moins deux sorties de comptage (a, b), et dont la sortie non inverseuse est raccordée à l'entrée d'un second étage à bascule (FF2), dont l'entrée de cadence est raccordée à la seconde sortie (b) du compteur (Z1), et que les sorties (SLA, SLB) de l'étage à bascule (FF2) sont raccordées respectivement à l'entrée de commande d'un interrupteur ($S_A$, $S_B$), et qu'un premier potentiel ($V_H$) chargeant le condensateur ($C_M$) est appliqué lorsque le premier interrupteur ($S_A$) est fermé, qu'un second potentiel ($V_T$) déchargeant le condensateur ($C_M$) est appliqué lorsque le second interrupteur ($S_B$) est fermé, le second potentiel ($V_T$) étant plus négatif que le premier potentiel ($V_H$) et le premier potentiel ($V_H$) étant plus négatif qu'un potentiel de référence (VR), qui est raccordé aux entrées inverseuses des comparateurs (K1, K2).

2. Circuit à valeur de seuil suivant la revendication 1, caractérisé par le fait qu'entre l'étage à bascule (FF2) et les interrupteurs ($S_A$, $S_B$) sont insérées deux portes ET ($G_A$, $G_B$) de telle sorte que les deux sorties (SLA, SLB) de l'étage à bascule (FF2) sont raccordées respectivement à une entrée des portes ET ($G_A$, $G_B$), dont la seconde entrée est raccordée à une troisième sortie (c) du compteur (Z1) et dont les sorties sont raccordées respectivement à l'entrée de commande d'un interrupteur ($S_A$, $S_B$).

3. Circuit à valeur de seuil suivant les revendications 1 et 2, caractérisé par le fait que les sorties (a) et (b) du compteur prennent la valeur "1" logique pour le même état de comptage.

Fig. 1

Fig. 2

EP 0 348 643 B1

Fig. 3